(19) **Europäisches Patentamt**
**European Patent Office**
**Office européen des brevets**

(11) **EP 2 623 999 B1**

(12) **EUROPÄISCHE PATENTSCHRIFT**

(45) Veröffentlichungstag und Bekanntmachung des Hinweises auf die Patenterteilung:
**07.04.2021 Patentblatt 2021/14**

(51) Int Cl.:
**G01R 31/11** *(2006.01)* **G01R 23/16** *(2006.01)*
**G01R 31/08** *(2020.01)*

(21) Anmeldenummer: **13000134.0**

(22) Anmeldetag: **11.01.2013**

(54) **Verfahren zum Verorten eines Kabelfehlers in einem Prüfkabel und zugehörige Vorrichtung**

Method for locating a cable fault in a test cable and corresponding device

Procédé de localisation d'une faute dans un câble de test et dispositif correspondant

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.02.2012 DE 102012002439**
**28.03.2012 DE 102012006332**

(43) Veröffentlichungstag der Anmeldung:
**07.08.2013 Patentblatt 2013/32**

(73) Patentinhaber: **Hagenuk KMT Kabelmesstechnik GmbH**
**01471 Radeburg (DE)**

(72) Erfinder:
• **Scheuschner, Sven**
**D-01471 Radeburg (DE)**

• **Hirte, Matthias**
**D-39106 Magdeburg (DE)**
• **Petzold, Jörg**
**D-39120 Magdeburg (DE)**
• **Gebhardt, Thomas**
**D-01458 Ottendorf-Okrilla OT Medingen (DE)**

(74) Vertreter: **Marschall, Stefan et al**
**Elbpatent**
**Marschall & Partner PartGmbB**
**Jessenstrasse 4**
**22767 Hamburg (DE)**

(56) Entgegenhaltungen:
**US-A- 5 502 392 US-A1- 2004 230 387**
**US-A1- 2006 061 368 US-A1- 2008 048 668**

EP 2 623 999 B1

**Beschreibung**

Die Erfindung betrifft ein Verfahren zum Verorten eines Kabelfehlers in einem Prüfkabel mittels einer Prüfvorrichtung, wobei ein elektrisches System das Prüfkabel und die Prüfvorrichtung aufweist und eine Vorrichtung zum durchführen des Verfahrens.

Die Ortung von Fehlerstellen in Kabel-Systemen mit großer lokaler Ausdehnung oder hoher Komplexität ist Gegenstand vieler Patentanmeldungen (DE 22 010 24 A, US 2004/230387 A1, DE 196 172 43 A1, DE 100 194 30 A1, DE 24 550 07 A1). Die etablierten Verfahren nutzen die zeitliche Differenz zwischen einem ausgesendeten und empfangen Zeitsignal. Durch die Kenntnis der Impulsausbreitungsgeschwindigkeit ist es so möglich, die vom Impuls zurückgelegte Strecke zu berechnen.

Für eine genaue Bestimmung der Fehlerpositionen ist die Messung der aus der Leitung ausgekoppelten reflektierten Signale mit geringer Amplitude notwendig. Diese Messung wird durch vorhandene Störsignale erschwert, welche aus der Umgebung in das Kabel eingekoppelt werden. Durch eine Vielzahl möglicher Stoßstellen des Wellenwiderstandes der untersuchten Leitung treten Mehrfachreflexionen auf, die die Messdatenbewertung erschweren.

Aufgabe der Erfindung ist es den Stand der Technik zu verbessern.

Gelöst wird die Aufgabe durch ein Verfahren mit den Schritten des Anspruchs 1.

Durch das hier vorgeschlagene Verfahren kann die Ortung eines Kabelfehlers durch Ausnutzung der Resonanzeigenschaften des Kabels ermöglicht werden. Weiterhin können Maxima und deren Ordnung bestimmt werden, wodurch ein automatisches Bestimmen der elektrischen Länge des Prüfkabels erreichbar ist.

Bevor im Weiteren eine Definition der verwendeten Begrifflichkeiten dargelegt wird, wird die das Verständnis erleichternde zugrundeliegende mathematische Beschreibung des Problems erläutert.

Ein Energiekabel, wie beispielsweise ein Prüfkabel, kann als Resonator verstanden werden. Ausgehend von den Kirschoff'schen Gesetzen liefert die Leitungstheorie ein System gekoppelter Differentialgleichungen, die das dynamische Verhalten der Ströme und Spannungen auf einer Leitung beschreiben.

$$-\frac{\partial u(z,t)}{\partial z} = R' \cdot i(z,t) + L' \cdot \frac{\partial i(z,t)}{\partial t} \qquad (1)$$

$$-\frac{\partial i(z,t)}{\partial z} = G' \cdot u(z,t) + C' \cdot \frac{\partial u(z,t)}{\partial t} \qquad (2)$$

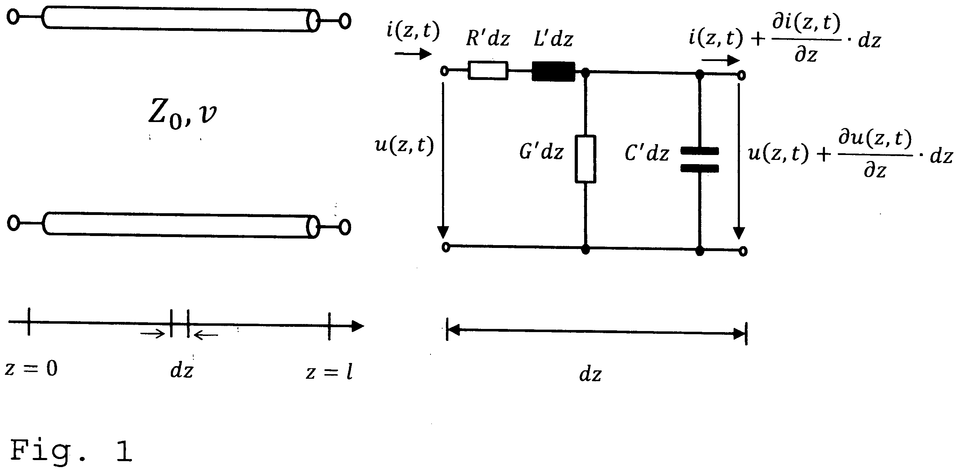

Die Größen $L'$, $C'$, $R'$, $G'$ geben die Leitungsgrößen pro Länge an und lassen sich anhand eines Ersatzschalbildes veranschaulichen(siehe Fig. 1).

Anders ausgedrückt beschreiben die Leitungsgleichungen (1) und (2) die Antwort des Systems "Leitung" auf eine äußere Anregung.

Die Art der Anregung, also die Form des Strom- oder Spannungssignals, welches der Leitung aufgeprägt wird, hat dabei entscheidenden Einfluss auf die Antwort. Wird das System harmonisch mit einer Frequenz angeregt, welche nahe der Resonanzfrequenz liegt, äußert sich das in einer Strom- und/oder Spannungsantwort mit maximaler Amplitude.

Ist die Resonanzfrequenz unbekannt, führt eine breitbandige Anregung, zum Beispiel ein Spannungseinbruch oder Stromimpuls mit niedrigen Anstiegszeiten, wie er beim Zünden eines Lichtbogens entsteht, zu einer Überlagerung der einzelnen harmonischen Anteile der Anregung und deren Reflexionen an den Enden der Leitung.

Wenn die sich überlagernde Wellen, welche in die gleiche Richtung laufen, einen Phasenversatz von einem Vielfachen von 360° haben, überlagern sich die Wellen konstruktiv und es kommt zur Ausbildung von stehenden Wellen.

Solche Wellen sind durch den fehlenden Phasenversatz von den Effekten einer destruktiven Überlagerung nicht betroffen und breiten sich aus diesem Grund über einen längeren Zeitraum aus.

Auf Basis dieses Phänomens kann bei einem unbekannten Leitungssystem durch Messung der Frequenzen, bei denen sich stehende Wellen ausbreiten, die elektrische Länge der Leitung ermittelt werden.

Aus der Bedingung für die konstruktive Überlagerung ergibt sich dann die folgende Beziehung.

$$L = n \cdot \frac{\lambda}{2} = n \cdot \frac{c}{2f} \qquad (3)$$

Die Leitungsgleichungen sind Differentialgleichungen, die mit dem Ansatz der ebenen Wellen

$$u(z, t) = \underbrace{u_1 \cdot e^{j\omega t - \gamma z}}_{\text{hinlaufende Welle}} + \underbrace{u_2 \cdot e^{j\omega t + \gamma z}}_{\text{rücklaufende Welle}} \qquad (4)$$

sowie

$$i(z, t) = \underbrace{\frac{u_1}{Z_0} \cdot e^{j\omega t - \gamma z}}_{\text{hinlaufende Welle}} - \underbrace{\frac{u_2}{Z_0} \cdot e^{j\omega t + \gamma z}}_{\text{rücklaufende Welle}} \qquad (5)$$

gelöst werden können, wobei $Z_0$ der Wellenwiderstand der Leitung

$$Z_0 = \sqrt{\frac{R' + j\omega L'}{G' + j\omega C'}} \qquad (6)$$

und $\gamma$ die komplexe Ausbreitungskonstante ist.

$$\gamma = \sqrt{(R' + j\omega L') \cdot (G' + j\omega C')} \qquad (7)$$

$\gamma$ ist komplex und besitzt einen Phasenanteil $\beta$, der die Phasendrehung eines infinitesimalen Leitungselementes angibt.

Die zuvor beschriebenen Gleichungen gelten nur für verlustlose ideale Leitungen. Für verlustbehaftete Leitungen hingegen wird die Frequenzabhängigkeit von $\gamma$ und $\beta$ durch eine hinzukommende Frequenzabhängigkeit aller Leitungsgrößen komplizierter. Es tritt Dispersion auf.

$\beta$ spielt für die Bestimmung der Fehlerentfernung eine entscheidende Rolle und kann auf einfachstem Weg nach Gleichung (8) durch ein Messen der frequenzabhängigen Phasengeschwindigkeit der Signale auf der Leitung ermittelt werden.

$$\beta = \frac{2\pi f}{c}. \qquad (8)$$

Die resultierende Lösung hat mit u1 und u2 zwei Unbekannte, sodass es unendlich viele Lösungen gibt.

Um die Leitungsgleichungen eindeutig lösen zu können, sind Randbedingungen erforderlich, an denen das Verhältnis zwischen Strömen und Spannungen bekannt ist. Ausgehend von diesen Randbedingungen kann mit Hilfe der Leitungsgleichungen der Strom- und Spannungsverlauf über die gesamte Leitung berechnet werden. An der Stelle der bekannten Randbedingung muss sowohl die Randbedingung selbst, als auch die Leitungsgleichung gelten. Für eine Abschlussimpedanz ZL an der Stelle z = 0 ergibt sich demnach

$$Z_L = \frac{U(z = 0)}{I(z = 0)} = \frac{u_1 \cdot e^{j\omega t} + u_2 \cdot e^{j\omega t}}{\frac{u_1}{Z_0} \cdot e^{j\omega t} - \frac{u_2}{Z_0} \cdot e^{j\omega t}}. \qquad (9)$$

Anschließendes Umstellen liefert den Reflexionsfaktor r.

$$r = \frac{u_2}{u_1} = \frac{Z_L - Z_0}{Z_L + Z_0} \qquad (10)$$

Mit r lassen sich die Leitungsgleichungen lösen. Der Reflexionsfaktor kann mit Hilfe eines Netzwerkanalysators direkt gemessen werden.

Da die Enden des Energiekabels mit einer bekannten Impedanz abgeschlossen sind, können sie als Randbedingung verwendet werden, denn ein Ende ist der Ort des Fehlers an dem der brennende Lichtbogen einen Kurzschluss darstellt, während das andere Ende mit dem Messgerät mit bekannter Eingangsimpedanz abgeschlossen ist.

Aus den vorherigen Angaben lässt sich die Fehlerentfernung wie folgt berechnen.

Aus den Lösungen der Leitungsgleichung lassen sich die Phasenbeziehungen aller sich auf der Leitung ausbreitenden Wellen aufstellen. Die gesamte Phasendrehung einer Welle, welche durch das Kabel hin und wieder zurück läuft ist

$$\varphi = \underbrace{\beta l}_{\text{hinlaufende Welle}} + \underbrace{\arg(r_2)}_{\text{Reflektion am Ende}} + \underbrace{\beta l}_{\text{rücklaufende Welle}} + \underbrace{\arg(r_1)}_{\text{Reflektion am Ende}} .$$

(11)

Nach der Leitungslänge I umgestellt, ergibt sich

$$l = (\Phi - \arg(r2) - \arg(r1))/2\beta$$

(12)

Es müssen also die folgenden frequenzabhängigen Parameter bekannt sein, um Leitungslänge I und/oder die Fehlerentfernung bestimmen zu können.

- Phasendrehung der Reflektion am ersten Ende der Leitung arg(r1)

- Phasendrehung der Reflektion am zweiten Ende der Leitung arg(r2)

- Gesamtphasendrehung $\phi$

- Imaginärteil $\beta$ der Ausbreitungskonstante $\gamma$

Das Bestimmen der Parameter wird im Ausführungsbeispiel dargestellt.

Diese Theorie vorweggenommen sei Folgendes Begriffliche erläutert.

Ein "Kabelfehler" umfasst sämtliche mit einer Spannung, insbesondere mit einer VLF-Spannung, intermittierende und/oder reversible/irreversible Isolationsfehler. Ein Kabelfehler liegt beispielsweise dann vor, wenn ein Isolationsdurchschlag gegeben ist. Ein reversibler Kabelfehler liegt insbesondere dann vor, wenn zu einem Isolationsdurchschlag kommt, jedoch ein Reparaturmechanismus die Kabelisolierung "heilt". Dies kann beispielsweise bei ölisolierten Kabeln geschehen, da es während eines Durchschlags zur Verflüssigung der Ölisolierung kommt, welche gegebenenfalls in einen ausgetrockneten kritischen Bereich der Isolierung nachfließt und zu einer Festigkeitserhöhung führt.

Unter einem "Verorten" eines Kabelfehlers ist unter anderem das Festlegen der Position oder das örtliche Einschränken des Kabelfehlers im Prüfkabel zu verstehen. Auch das Bestimmen der elektrischen Länge und abgeleitete Werte werden von dem Begriff "Verorten" umfasst. Die Position und somit der Ort des Kabelfehlers entspricht insbesondere der elektrischen Länge des Prüfkabels vom Messort alternativ ist die Position der "Ort" $\phi/\beta$ (siehe Gleichung 12). Die geometrische Länge I kann sich insbesondere aus elektrische Länge minus (Phasendrehung an den Kabelenden)/ $\beta$ ergeben. Somit kann bei Kenntnis des Verlaufes eines verlegten oder offen zugänglichen Kabels der Ort des Kabelfehlers klar eingegrenzt werden.

Ein "Prüfkabel" umfasst das zu untersuchende Kabel. Kabel sind insbesondere Mittelspannungskabel für eine VLF-Spannung sowie Hochspannungs- und Niederspannungskabel. Weiterhin sind vom Begriff Prüfkabel sämtliche Kabel mit einer Isolierung umfasst. Auch erdverlegte Kabel sind von der Begrifflichkeit abgedeckt.

Mit einer "Prüfvorrichtung" ist jegliches Messgerät zum Messen von elektrischen Kabeleigenschaften umfasst, welches mit dem Prüfkabel elektrisch gekoppelt ist. Mit der Prüfvorrichtung können insbesondere die Zeit- und/oder Frequenzsignale von elektrischen Schwingungen und elektrischen Wellen im Prüfkabel, Phasendrehungen der Reflexionen an den Enden des Prüfkabels, die Gesamtphasendrehung, der Imaginärteil $\beta$ der Ausbreitungskonstante $\gamma$ oder der Wellenwiderstand der Leitung gemessen werden. Die Prüfvorrichtung kann zudem das elektrische System zum elektrischen Schwingen anregen. Dies erfolgt beispielsweise durch einen Stoßgenerator, welcher von der Prüfvorrichtung umfasst ist. Der Stoßgenerator kann dabei schmalbandige oder breitbandige Burst-Signale dem Prüfkabel aufprägen. Ebenfalls kann die Prüfvorrichtung das Zünden eines Lichtbogens initiieren.

Das "elektrische System" umfasst sowohl das Prüfkabel als auch das elektrisch gekoppelte Messsystem und kann insbesondere als solches simuliert und modelliert werden. Somit können einzelne Parameter bestimmt werden.

Mit "erster Phasendrehung" und "zweiter Phasendrehung" sind die Parameter der mathematischen Repräsentationen $\arg(r_1)$ und $\arg(r_2)$ umfasst, wie sie in Gleichung (11) und (12) verwendet werden.

Das "erste Prüfkabelende" und das "zweite Prüfkabelende" umfassen zum einen den Ort des Kabelfehlers als auch das offene Ende des Prüfkabels oder den Ort der elektrischen Kopplung zur Prüfvorrichtung.

Als "Ausbreitungskonstante" ist der Parameter der mathematischen Repräsentationen $\gamma$ umfasst, wie dieser in der Gleichung (7) verwendet wird.

Ein "elektrisches Schwingen" im Prüfkabel oder im elektrischen System umfasst sowohl einzelne elektrische Schwingungen im Prüfkabel oder im elektrischen System als auch sich ausbildende (stehende) Wellen. Das elektrische Schwingen kann insbesondere durch Zünden eines Lichtbogens oder durch Aufprägen eines (breitbandigen) Signals in dem elektrischen System oder dem Prüfkabel erzeugt werden.

Unter "Messen der elektrischen Schwingung" ist insbesondere ein Messen eines Zeitsignals des Stroms, der Spannung, des E-Felds oder des magnetischen Felds umfasst. Ebenfalls umfasst ist das Messen mittels eines Spektrum Analysers, welcher das Zeitsignal bereits in ein Frequenzsignal transformiert hat.

Bei der "Frequenzanalyse" werden insbesondere überlagerte Zeitsignale unterschiedlicher Schwingungsdauern und Anstiegszeiten separiert. Dabei kann beispielsweise eine Fast-Fourier-Transformation (FFT) oder ein elektronischer Filter eingesetzt werden, welcher die Bandbreite des Messsystems auf die spektralen Anteile des Nutzsignals begrenzt. Durch das Anwenden der FFT oder des Filters ergibt sich das "Frequenzspektrum". Allgemein umfasst das Frequenzspektrum jegliche Repräsentation der Frequenzen des Zeitsignals.

Als "Gesamtphasendrehung" ist der Parameter der mathematischen Repräsentationen $\phi$ umfasst, wie dieser in den Gleichungen (11) und (12) verwendet wird.

Eine "elektrische Länge" ist der Parameter der mathematischen Repräsentationen l umfasst, wie dieser in den Gleichungen (11) und (12) verwendet wird. Praktisch kann diese der Länge vom einen Prüfkabelende zum Ort des Kabelfehlers entsprechen. Zudem gelten die Ausführungen, welche zum Begriff "Verorten" dargelegt wurden.

Um einen Nutzer ohne zusätzlichen Aufwand und ohne vertiefende Erfahrung den Ort des Kabelfehlers mittzuteilen, kann die Frequenzanalyse ein automatisches Detektieren von relevanten Maxima umfassen. Ein einfaches Bestimmen der (lokalen) Maxima kann beispielsweise dadurch erfolgen, dass ein Vergleich mit dem jeweils rechts und links benachbarten Datenpunkt erfolgt.

In einer Ausprägungsform kann das automatische Detektieren eines relevanten Maximums anhand einer Intervallbreite und/oder eines Grenzwertes erfolgen. Somit können "parasitäre" Maxima und nicht aufgelöste Maxima erkannt und bereinigt werden.

"Parasitäre Maxima" können insbesondere durch breitbandiges Rauschen und/oder durch überlagerte Störsignale auftreten, welche beispielsweise durch auftretende Inhomogenitäten der Kabelimpedanz entstehen.

Um Störeffekte und parasitäre Maxima auszuschließen und die Signalqualität des Frequenzspektrums zu verbessern, kann das automatische Detektieren das Anwenden eines Filters mit variabler Grenzfrequenz auf das Frequenzspektrum umfassen und das Anwenden des Filters mit variabler Grenzfrequenz eine Frequenztransformation des Frequenzspektrums mit anschließender Multiplikation einer veränderbaren Fensterfunktion und abschließender Rücktransformation in ein bereinigtes Frequenzspektrum aufweisen, und im bereinigten Frequenzspektrum die relevanten Maxima bestimmt werden.

In einer weiteren Ausprägungsform kann beim Anwenden des Filters mit variabler Grenzfrequenz ein relevantes Maximum oder mehrere relevante Maxima verschoben werden. Somit kann das Auflösen der Maxima verbessert werden.

Um das Modellieren oder Simulieren des Ortes des Kabelfehlers zu ermöglichen und/oder zu verbessern, können die Ordnungen der relevanten Maxima des Frequenzspektrums oder des bereinigten Frequenzspektrums bestimmt werden. Auch können die Ordnungen der Maxima des Zeitsignals bestimmt werden.

In einer weiteren Ausgestaltung des Verfahrens kann jedem relevanten Maximum ein Zuverlässigkeitswert zugeordnet werden. Durch unterschiedliche Auswahl von Maxima, welche anhand des Zuverlässigkeitswerts erfolgt, können unterschiedliche Simulations- oder Modellierungsergebnisse erhalten werden.

Um das Ergebnis des Bestimmens der Kabellänge und somit des Ortes des Kabelfehlers zu verbessern, kann für verschiedene Zuverlässigkeitsniveaus ein elektrisches Schwingverhalten, insbesondere eine Durchschlagsspannung und die elektrische Länge des Prüfkabels, modelliert werden.

Ein "Zuverlässigkeitsniveau" kann einem Grenzwert entsprechen unterhalb dessen ein Maximum als nicht relevant charakterisiert wird.

Das "Modellieren" umfasst ebenfalls ein Simulieren des elektrischen Systems oder des Prüfkabels. Als Modellierungstool kann insbesondere "SPICE" (Simulation Program with Integrated Circuits Emphasis; Programm zur Simulation von elektronischen Schaltungen) oder Matlab/Simulink eingesetzt werden.

In einer zusätzlichen Ausprägungsform kann das Messen des aufgeprägten Schwingens in einem Zeitbereich erfolgen und mittels einer Transformation in einen Frequenzbereich überführt werden. Somit kann letztendlich das Verorten eines Kabelfehlers verbessert oder erst ermöglicht werden.

In einem weiteren Aspekt der Erfindung wird die Aufgabe gelöst durch eine Vorrichtung, die jeweilige Mittel aufweist, die eingerichtet sind, die jeweiligen Schritte eines zuvor beschriebenen Verfahrens durchzuführen. Somit kann eine Vorrichtung am Ort der Untersuchung zur Analyse von Kabelfehlern bereitgestellt werden.

Im Weiteren wird die Erfindung anhand von Ausführungsbeispielen weiter erläutert. Es zeigt

Fig. 1     eine schematische Darstellung eines Ersatzschaltbildes einer Leitung mit zugehörigen mathematischen Beschreibungen.

Um die elektrische Länge oder weitere Parameter zu bestimmen werden folgende Parameter bestimmt oder gemessen.

Die Reflexionsfaktoren sind vom Kabel unabhängige Größen und sind separat bestimmt worden.

Während der Prüfung ist eines der Enden des Kabels mit der Impedanz des Prüfgerätes, welches die Hochspannung erzeugt und die Messsignale auskoppelt, abgeschlossen.

Die Phasendrehung am ersten Ende der Leitung und die Impedanz werden einmalig frequenzabhängig vermessen und anschließend gespeichert.

Die Phasendrehung am zweiten Ende der Leitung wird als bekannt angenommen, da dort im Fehlerfall annähernd ein Kurzschluss vorliegt.

Die Ausbreitungskonstante ist von der Geometrie und dem Materials des Kabels abhängig. Sie ist bei Kabeln eines Typs immer annähernd gleich und schwankt dann nur auf Grund der Fertigungstoleranzen. Der Imaginärteil der Ausbreitungskonstante eines Kabels wird entweder über das Datenblatt (meist nicht frequenzabhängig) oder über die Messung der frequenzabhängigen Phasengeschwindigkeit bestimmt. Alternativ erfolgt eine direkte Messung.

Die Gesamtphasendrehung ergibt sich aus der Resonanzbedingung (siehe Gleichung (3)), also den Resonanzfrequenzen und deren Ordnungen, welche wie nachfolgend dargelegt automatisch ermittelt werden und unter der sich durch die Anregung des Systems stehende Wellen zwischen Fehlerort und dem Messende des Kabels ausbilden.

Im Weiteren werden das automatische Detektieren der Resonanzfrequenzen und deren Ordnungen (Frequenzanalyse) erläutert.

Allgemein dienen Messungen zum Informationsgewinn. Doch nicht immer lassen sich die in einem Zeitsignal enthaltenen Informationen leicht erfassen und auslesen. Häufig führen Überlagerungen des Nutzsignals durch Rauschen und Störsignalen zu einer erschwerten und ungenauen Auswertung. Hier können bereits unterschiedliche Darstellungsformen desselben Datensatzes hilfreich sein.

So werden sich überlagernde Signale mit unterschiedlichen Schwingungsdauern und Anstiegszeiten mit einer Fast-Fourier-Transformation (FFT) separiert.

Alternativ wird ein elektronischer Filter eingesetzt, welcher die Bandbreite des Messsystems auf die spektralen Anteile des Nutzsignals begrenzt.

Für den Fall, das die spektralen Anteile von Nutz- und Störsignalen zu dicht aneinander liegen, um sie im Frequenzbereich trennen zu können und/oder die spektralen Anteile des Nutzsignales im Vorfeld unbekannt sind, diese unter Umständen sogar die gesuchte Messgröße sind, erfolgt die im Weiteren beschriebene Auflösung der Maxima.

Zur Lösung der Gleichungen zur Bestimmung der Fehlerentfernung ist in jedem Fall eine Analyse des Frequenzspektrums des aufgenommenen Zeitsignals im Fehlerfall nötig. Ziel ist die zuverlässige und automatische Detektion der relevanten Maxima im Spektrenverlauf. Dabei kommt es nicht nur auf das einzelne Maximum an, sondern auch auf dessen Ordnung. Wird ein relevantes Maximum nicht erkannt, so wird den zu höheren Frequenzen nachfolgenden Peaks eine falsche Ordnung zugewiesen, was sich dann auf die Berechnung der Fehlerentfernung auswirken würde.

Dabei muss mit zwei grundsätzlichen Problemstellungen umgegangen werden. Zum einen unterliegt das gemessene Zeitsignal diversen Störungen, wie einem breitbandigem Rauschen oder überlagernden Störsignalen, die durch auftretende Inhomogenitäten der Kabelimpedanz entstehen. Dies wirkt sich ebenso auf das Spektrum aus, sodass die Daten nicht als glatter Verlauf vorliegen und "parasitäre" Maxima auftreten. Diese Schwankungen lassen die Anwendung einfacher Algorithmen auf die Rohdaten zur Bestimmung von Maxima nicht zu. Der denkbar einfachste Weg ein lokales Maximum zu finden, der Vergleich mit dem jeweils rechts und links benachbarten Datenpunkt, würde eine Vielzahl falscher Maxima ermitteln.

Realisiert wird dies durch die Erweiterung der Methode mit Hilfe zusätzlicher Parameter, wie etwa der, bei der eine Intervallbreite eingeführt ist, in der lokal nach Maxima gesucht wird oder alternativ der bei der eine Grenzwert eingeführt ist, welcher festlegt, ab welchem Pegelunterschied ein Maximum auch als solches zugelassen wird.

Aus diesem Grund werden Werte z.B. für die Intervallbreite und/oder Peakhöhe gewählt. Dabei besteht die grundsätzliche Problematik, dass der günstigste Wert für solche Grenzwerte von im Vorfeld unbekannten Systemgrößen abhängt. Im Wesentlichen sind das die Durchschlagspannung und die Fehlerentfernung. Um diese zu bestimmen wird folgender Lösungsansatz verfolgt.

Der Ansatz der Peakdetektion-Funktion ist, jedes Maximum im untersuchten Bereich zu finden, also auch die parasitären Maxima, welche durch Rauschen oder zusätzliche Inhomogenitäten innerhalb der Kabelimpedanz entstehen, und nach gewissen Kriterien zu bewerten.

Jedem der Maxima wird dabei ein Wert zugeordnet, welcher ein Zuverlässigkeitsniveau angibt. Mit Hilfe dieser zusätzlichen Information werden anschließend eine Reihe von Proberechnungen anhand eines einfachen SPICE-Modells für eine Leitung der bestimmten Länge durchgeführt, bei denen im ersten Schritt alle Maxima über einem Mindest-Vertrauenswert berücksichtigt werden.

Stimmen jene nicht, oder nur schlecht mit den Ergebnissen der Proberechnung überein, werden weitere Maxima ausgeschlossen, beginnend mit dem niedrigsten verbliebenen Vertrauenswert. Die beste Lösung wird dem Anwender schließlich angezeigt.

Um die Maxima besser zu bestimmen, wird ein skalenvariables Filterkonzept auf das Frequenzspektrum angewendet. Das bedeutet, das Spektrum selbst wird als Summation harmonischer Funktionen betrachtet.

Das Frequenzspektrum wird, wie ursprünglich der Zeitverlauf, einer weiteren Fast-Fourier-Transformation (FFT) unterzogen. Das Ergebnis wird mit einer Fensterfunktion multipliziert und anschließend zurück transformiert.

Mit Hilfe einer Fensterfunktion (Rechteckfunktion oder eine angenäherte Rechteckfunktion) mit gewisser Breite werden Teile des Spektrums herausgefiltert. Auf diese Weise ist auch eine Glättung des Spektrums möglich, was das Ermitteln von lokalen Maxima vereinfacht.

Eine kontinuierlich veränderliche Fensterfunktion, durch die dem Spektrum schrittweise harmonische Anteile hinzugefügt oder entfernt werden, realisiert vorliegend eine skalenvariable Analyse des "Orginalspektrums".

In jedem dieser Schritte werden die Frequenzen und der Pegelunterschied zwischen den Maxima und den jeweiligen benachbarten Minima des rekonstruierten, geglätteten Spektrums bestimmt und gespeichert.

Im Anschluss wird dann ermittelt, wie häufig und mit welcher Ausprägung Maxima bei den jeweiligen Frequenzen aufgetreten sind. So wird eine gewichtete Häufigkeitsverteilung bestimmt, welche als Maß für die Zuverlässigkeit der jeweiligen Maxima dient.

Das Spektrum wird somit nach seinen enthaltenen harmonischen Anteilen "abgescannt". Dabei entsprechen die Start- und Endwerte für die Breite der Fensterfunktion dem betrachteten Bereich zwischen einer angenommenen minimalen und maximalen Fehlerentfernung. Der große Vorteil dieser Methode ist, dass sie auf Spektren mit verschiedenen Skalenverhältnissen anwendbar ist, ohne dass manuelle Anpassungen der Detektion notwendig werden.

Um für Peaks mit besonders geringem Pegel oder großen Peakbreiten die Detektion zu verbessern, werden leichte Verschiebungen der Maxima während der schrittweisen Filterung des Spektrums berücksichtigt. Dazu wird der charakteristische Verlauf in Intervalle aufgeteilt, welche mit hoher Wahrscheinlichkeit zu nur einem Maximum gehören.

Die Fläche des Verlaufs innerhalb der Intervalle wird durch numerische Integration ermittelt und das Ergebnis dem höchsten Wert innerhalb des Intervalls zugeschrieben. Das Ergebnis ist schließlich ein Datensatz, welcher die Frequenzen aller ermittelten Maxima, sowie die dazugehörigen Zuverlässigkeitswerte enthält. Dieser wird dann an den Algorithmus zur Bestimmung der Fehlerentfernung übergeben.

Die ermittelten Zuverlässigkeitswerte sind dabei als rein relative Bewertung zu verstehen. Auf eine Normierung wird verzichtet, da jeder Wert, auf den normiert wird, willkürlich gewählt wäre.

**Patentansprüche**

1. Verfahren zum Verorten eines Kabelfehlers in einem Prüfkabel mittels einer Prüfvorrichtung, wobei ein elektrisches System das Prüfkabel und die Prüfvorrichtung aufweist und das Verfahren folgende Schritte umfasst:

   - Ermitteln einer ersten Phasendrehung arg(r1) an einem ersten Prüfkabelende, einer zweiten Phasendrehung arg (r2) an einem zweiten Prüfkabelende und des Imaginärteils β einer Ausbreitungskonstante des Prüfkabels, wobei das erste Prüfkabelende und das zweite Prüfkabelende zum einen den Ort des Kabelfehlers als auch das offene Ende des Prüfkabels oder den Ort der elektrischen Kopplung zur Prüfvorrichtung umfassen,
   - Anregen des elektrischen Systems oder des Prüfkabels, sodass das dem elektrischen System oder dem Prüfkabel ein elektrisches Schwingen aufgeprägt wird,
   - Messen des aufgeprägten Schwingens, sodass ein Frequenzspektrum bestimmt wird,
   - Frequenzanalyse des Frequenzspektrums,
   - Bestimmen anhand der Frequenzanalyse einer Gesamtphasendrehung φ und

- Bestimmen einer elektrischen Länge 1 des Prüfkabels als $l = \frac{\Phi - \arg(r2) - \arg(r1)}{2\beta}$.

2. Verfahren nach Anspruch 1, wobei die Frequenzanalyse ein automatisches Detektieren von relevanten Maxima umfasst.

3. Verfahren nach Anspruch 2, wobei das automatische Detektieren eines relevanten Maximums anhand einer Intervallbreite und/oder eines Grenzwertes erfolgt.

4. Verfahren nach Anspruch 2 oder 3, wobei das automatische Detektieren das Anwenden eines Filters mit variabler Grenzfrequenz auf das Frequenzspektrum umfasst und das Anwenden des Filters mit variabler Grenzfrequenz eine Frequenztransformation des Frequenzspektrums mit anschließender Multiplikation einer veränderbaren Fensterfunktion und abschließender Rücktransformation in ein bereinigtes Frequenzspektrum aufweist, und im bereinigten Frequenzspektrum die relevanten Maxima bestimmt werden.

5. Verfahren nach Anspruch 4, wobei beim Anwenden des Filters mit variabler Grenzfrequenz ein relevantes Maximum oder mehrere relevante Maxima verschoben werden.

6. Verfahren nach einem der Ansprüche 2 bis 5, wobei Ordnungen der relevanten Maxima des Frequenzspektrums oder des bereinigten Frequenzspektrums bestimmt werden.

7. Verfahren nach einem der Ansprüche 2 bis 6, wobei jedem relevanten Maximum ein Zuverlässigkeitswert zugeordnet wird.

8. Verfahren nach einem der vorherigen Ansprüche, wobei für verschiedene Zuverlässigkeitsniveaus ein elektrisches Schwingverhalten, insbesondere eine Durchschlagsspannung und die elektrische Länge des Prüfkabels, modelliert werden.

9. Verfahren nach einem der vorherigen Ansprüche, wobei das Messen des aufgeprägten Schwingens in einem Zeitbereich erfolgt und mittels einer Transformation in einen Frequenzbereich überführt wird.

10. Vorrichtung, die jeweilige Mittel aufweist, die eingerichtet sind, die jeweiligen Schritte eines Verfahrens nach einem der vorherigen Ansprüche durchzuführen.

**Claims**

1. A method for locating a cable fault in a test cable by means of a test device, wherein an electrical system includes the test cable and the test device, and wherein the method comprises the following steps:

   - determining a first phase shift arg(r1) at a first test cable end, a second phase shift arg(r2) at a second test cable end and the imaginary portion $\beta$ of a propagation constant of the test cable, wherein the first test cable end and the second test cable end comprise both the location of the cable fault and the open end of the test cable or the location of the electrical coupling to the test device,
   - exciting the electrical system or the test cable such that an electrical oscillation is imparted on the electrical system or the test cable,
   - measuring the imparted oscillation such that a frequency spectrum is determined,
   - analysing the frequency of the frequency spectrum,
   - determining a total phase shift $\Phi$ on the basis of the frequency analysis, and

   - determining an electrical length 1 of the test cable as $l = \frac{\Phi - \arg(r2) - \arg(r1)}{2\beta}$ .

2. The method according to claim 1, wherein the frequency analysis includes an automatic detection of relevant maxima.

3. The method according to claim 2, wherein the automatic detection of a relevant maximum is performed on the basis of an interval width and/or a threshold value.

4. The method according to claim 2 or 3, wherein the automatic detection comprises applying a filter with a variable cut-off frequency to the frequency spectrum, wherein the application of the filter with variable cut-off frequency includes a frequency transformation of the frequency spectrum with subsequent multiplication of a variable window function and a finalising reverse transformation into an adjusted frequency spectrum, and wherein the relevant maxima are determined in the adjusted frequency spectrum.

5. The method according to claim 4, wherein one relevant maximum or multiple relevant maxima are shifted when applying the filter with variable cut-off frequency.

6. The method according to any one of claims 2 to 5, wherein orders of the relevant maxima of the frequency spectrum or of the adjusted frequency spectrum are determined.

7. The method according to any one of claims 2 to 6, wherein a reliability coefficient is assigned to each relevant maximum.

8. The method according to any one of the preceding claims, wherein an electrical oscillation behavior, in particular a breakdown voltage and the electrical length of the test cable, are modeled for different reliability levels.

9. The method according to any one of the preceding claims, wherein the measurement of the imparted oscillation is performed in a time range and is converted into a frequency range by means of a transformation.

10. A device having the respective means designed to perform the respective steps of a method according to any one of the preceding claims.

**Revendications**

1. Procédé de localisation d'un défaut de câble dans un câble de contrôle au moyen d'un dispositif de contrôle, dans lequel un système électrique présente le câble de contrôle et le dispositif de contrôle et le procédé comprend les étapes suivantes :

   - détermination d'une première rotation de phase arg(r1) à une première extrémité de câble de contrôle, d'une seconde rotation de phase arg(r2) à une seconde extrémité de câble de contrôle et de la partie imaginaire $\beta$ d'une constante de diffusion du câble de contrôle, la première extrémité de câble de contrôle et la seconde extrémité de câble de contrôle comprenant d'une part l'endroit du défaut de câble et d'autre part l'extrémité ouverte du câble de contrôle ou l'endroit du couplage électrique du dispositif de contrôle,
   - excitation du système électrique ou du câble de contrôle, de manière à ce qu'une vibration électrique soit appliquée au système électrique ou au câble de contrôle,
   - mesure de la vibration appliquée de manière à déterminer un spectre de fréquence,
   - analyse de fréquence du spectre de fréquence,
   - détermination, sur la base de l'analyse de fréquence, d'une rotation de phase globale $\Phi$ et
   - détermination d'une longueur électrique 1 du câble de contrôle en tant que $l = \frac{\Phi - \arg(r2) - \arg(r1)}{2\beta}$.

2. Procédé selon la revendication 1, dans lequel l'analyse de fréquence comprend une détection automatique de maxima corrélatifs.

3. Procédé selon la revendication 2, dans lequel la détection automatique d'un maximum corrélatif a lieu sur la base d'une amplitude d'intervalle et/ou d'une valeur limite.

4. Procédé selon la revendication 2 ou 3, dans lequel la détection automatique comprend l'utilisation d'un filtre avec une fréquence limite variable sur le spectre de fréquence et l'utilisation d'un filtre à fréquence limite variable présente une transformation de fréquence du spectre de fréquence suivie d'une multiplication d'une fonction de fenêtre modifiable et pour finir d'une retransformation en un spectre de fréquences nettoyé et les maxima corrélatifs sont déterminés dans le spectre de fréquences nettoyé.

5. Procédé selon la revendication 4, dans lequel, en cas d'application du filtre avec une fréquence limite variable, un maximum corrélatif ou plusieurs maxima corrélatifs sont décalés.

6. Procédé selon l'une quelconque des revendications 2 à 5, dans lequel des ordres des maxima corrélatifs du spectre de fréquence ou du spectre de fréquence nettoyé sont déterminés.

7. Procédé selon l'une quelconque des revendications 2 à 6, dans lequel une valeur de fiabilité est attribuée à chaque maximum corrélatif.

8. Procédé selon l'une quelconque des revendications précédentes, dans lequel, pour différents niveaux de fiabilité, un comportement vibratoire électrique, en particulier une tension de claquage, et la longueur électrique du câble de contrôle sont modélisées.

9. Procédé selon l'une quelconque des revendications précédentes, dans lequel la mesure de la vibration appliquée a lieu pendant un laps de temps et est transposée dans une plage de fréquence au moyen d'une transformation.

10. Dispositif qui présente des moyens respectifs qui sont conçus pour exécuter les étapes respectives d'un procédé selon l'une quelconque des revendications précédentes.

$Z_0, v$

$i(z,t)$    $R'dz$    $L'dz$       $i(z,t) + \dfrac{\partial i(z,t)}{\partial z} \cdot dz$

$u(z,t)$     $G'dz$    $C'dz$    $u(z,t) + \dfrac{\partial u(z,t)}{\partial z} \cdot dz$

$z = 0$         $dz$        $z = l$            $dz$

Fig. 1

EP 2 623 999 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 2201024 A
- US 2004230387 A1
- DE 19617243 A1
- DE 10019430 A1
- DE 2455007 A1